# EUROPEAN PATENT APPLICATION

(11) **EP 4 016 616 A1**
(43) Date of publication of application: **22.06.2022**
(21) Application number: 21198458.8
(22) Date of filing: 23.09.2021
(51) Int. Cl.: H01L 23/498

(54) **NOVEL LGA ARCHITECTURE FOR IMPROVING RELIABILITY PERFORMANCE OF METAL DEFINED PADS**

(30) Priority: 21.12.2020 US 202017129846
(71) Applicant: Intel Corporation, Santa Clara, CA 95054 (US)
(72) Inventor: DUBEY, Manish, Chandler, 85249 (US); ARAKERE, Guruprasad, Chandler, 85226 (US); KULKARNI, Deepak, Chandler, 85286 (US); AGRAHARAM, Sairam, Chandler, 85295 (US); JEN, Wei-Lun, Chandler, 85226 (US); AHMED, Numair, Chandler, 85286 (US); GANESAN, Kousik, Chandler, 85249 (US); JADHAV, Amol, Chandler, 85226 (US); LEE, Kyu Oh, Chandler, 85286 (US)
(74) Representative: 2SPL Patentanwälte PartG mbB

(57) **Abstract**

Embodiments disclosed herein include electronic packages and methods of forming such electronic packages. In an embodiment, an electronic package comprises a package substrate with a die side and a land side. In an embodiment, a pad is on the land side. In an embodiment, a dielectric layer covers sidewalls of the pad, and a surface finish is over an exposed surface of the pad.

## Description

### TECHNICAL FIELD

Embodiments of the present disclosure relate to electronic packages, and more particularly to metal defined pads with improved architectures to increase reliability performance.

### BACKGROUND

With the increase in electrical performance demands, the budget for electrical losses (e.g., insertion loss, return loss, cross-talk, etc.) is shrinking. This requires optimization of the physical connections in the package. One of the approaches that the microelectronics industry is driving towards is the use of metal defined (MD) pads. MD pads are smaller in size compared to the current solder-mask defined (SMD) pads. SMD pads can be smaller in size as well, but due to their architecture, they have part of the pad buried under the solder mask. This reduces the active area of socket engagement. MD pads provide a middle ground to provide the needs for socket swipe as well as smaller copper area for reducing electrical losses.

One major challenge identified in MD pad approaches is the cracking of the buildup film near the foot of the MD pad. This is an intrinsic problem with the design of the pad. Particularly, during thermal cycling, high stresses develop at the outer edge of the MD pad in the buildup film. These high stresses can result in a crack that propagates down into the underlying buildup layers of the package substrate.

### BRIEF DESCRIPTION OF THE DRAWINGS

Figure 1A is a plan view illustration of a metal defined (MD) pad.
Figure 1B is a cross-sectional illustration of the MD pad in Figure 1A that illustrates cracking in the buildup film of the package substrate.
Figure 2 is a cross-sectional illustration of a package substrate with an MD pad with a dielectric layer over sidewall surfaces of the MD pad, in accordance with an embodiment.
Figure 3 is a cross-sectional illustration of a package substrate with an MD pad with a solder resist layer over sidewall surfaces of the MD pad, in accordance with an embodiment.
Figure 4 is a chart illustrating the reduction in stress proximate to the footing of MD pads described herein compared to existing MD pad architectures, in accordance with an embodiment.
Figure 5A is a cross-sectional illustration of a package substrate with a pad formed over a seed layer, in accordance with an embodiment.
Figure 5B is a cross-sectional illustration of the package substrate after the seed layer is removed, in accordance with an embodiment.
Figure 5C is a cross-sectional illustration of the package substrate after a dielectric layer is provided over the pad, in accordance with an embodiment.
Figure 5D is a cross-sectional illustration of the package substrate after the dielectric layer is recessed to expose a surface of the pad, in accordance with an embodiment.
Figure 5E is a cross-sectional illustration of the package substrate after a solder resist is provided over the dielectric layer, in accordance with an embodiment.
Figure 5F is a cross-sectional illustration of the package substrate after a surface finish is provided over the exposed surface of the pad, in accordance with an embodiment.
Figure 6A is a cross-sectional illustration of a package substrate with a die side and a land side, where MD pads are provided on the land side, in accordance with an embodiment.
Figure 6B is a cross-sectional illustration of the package substrate after a protective layer is provided over the die side of the package substrate, in accordance with an embodiment.
Figure 6C is a cross-sectional illustration of the package substrate after a dielectric layer is provided over the MD pads, in accordance with an embodiment.
Figure 6D is a cross-sectional illustration of the package substrate after the dielectric layer is recessed to expose a surface of the MD pads, in accordance with an embodiment.
Figure 6E is a cross-sectional illustration of the package substrate after the protective layer is removed from the die side, in accordance with an embodiment.
Figure 6F is a cross-sectional illustration of the package substrate after a solder resist layer is provided over the die side and the land side, in accordance with an embodiment.
Figure 6G is a cross-sectional illustration of the package substrate after solder resist openings are formed through the land side solder resist layer to expose the MD pads, in accordance with an embodiment.
Figure 6H is a cross-sectional illustration of the package substrate after a surface finish is applied over the MD pads, in accordance with an embodiment.
Figure 6I is a cross-sectional illustration of the package substrate after first level interconnects (FLIs) are formed over the die side of the package substrate, in accordance with an embodiment.
Figure 7A is a cross-sectional illustration of an electronic system with a package substrate with MD land side pads that is coupled to a board by solder balls, in accordance with an embodiment.
Figure 7B is a cross-sectional illustration of an electronic system with a package substrate with MD land side pads that is coupled to a board by a socket, in accordance with an embodiment.
Figure 8 is a schematic of a computing device built in accordance with an embodiment.

### EMBODIMENTS OF THE PRESENT DISCLOSURE

Described herein are electronic packages with metal defined pads with improved architectures to increase reliability performance, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

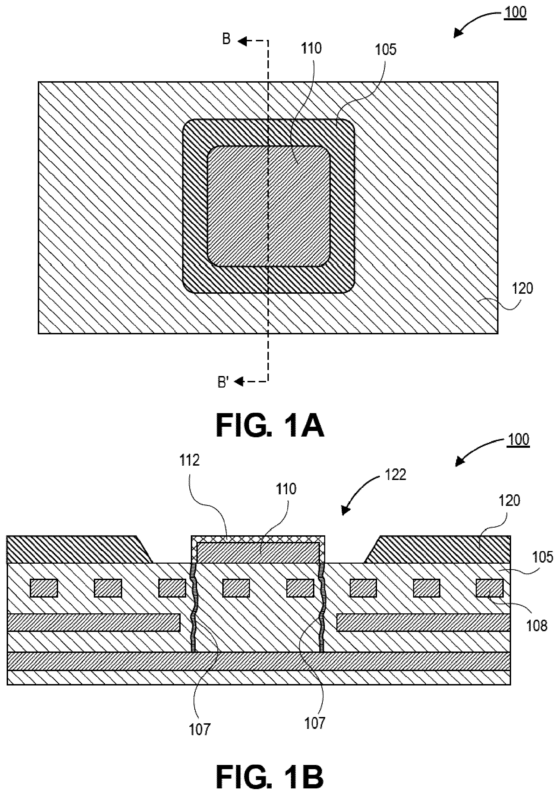

As noted above, metal defined (MD) pads have reliability issues. Particularly, the package substrate below the MD pads is susceptible to cracking due to stress concentrations that develop at the footings of the MD pads. An example of such an MD pad is shown in Figures 1A and 1B. Figure 1A is a plan view illustration of an electronic package 100 with an MD pad 110. As shown the solder resist 120 is spaced away from edges of the MD pad 110. That is, portions of the underlying package substrate 105 are visible in the plan view.

Referring now to Figure 1B, a cross-sectional illustration of the electronic package 100 in Figure 1A along line B-B' is shown. As shown, a solder resist opening 122 is provided in the solder resist 120 to expose the MD pad 110. The MD pad 110 may also comprise a surface finish 112 over a top surface and sidewall surfaces of the MD pad 110. The width of the solder resist opening 122 may be wider than a width of the MD pad 110 so that portions of the underlying package substrate 105 are exposed. The package substrate 105 may comprise conductive routing 108, such as pads, traces, vias, and the like.

Such MD pad 110 architectures result in high stresses being formed at the footing of the MD pad 110 during thermal cycling. Particularly, the high stress regions are adjacent to the bottom portion of the sidewalls of the MD pad 110. The high stresses provide a reliability risk to the electronic package. For example, the concentrated stresses may result in the formation of cracks 107 into the underlying buildup layers of the package substrate 105. The formation of cracks in the buildup layers presents a substantial reliability risk.

Accordingly, embodiments disclosed herein include MD pad architectures that minimize the stress concentrations at the footing of the MD pad. For example, embodiments may include providing a dielectric layer over the buildup layer that surrounds the sidewalls of the MD pad. In alternative embodiments, the solder resist may be formed along sidewalls of the MD pad to provide stress reduction. Such embodiments are different than solder mask defined (SMD) pads in that the solder resist does not contact the top surface of the MD pad.

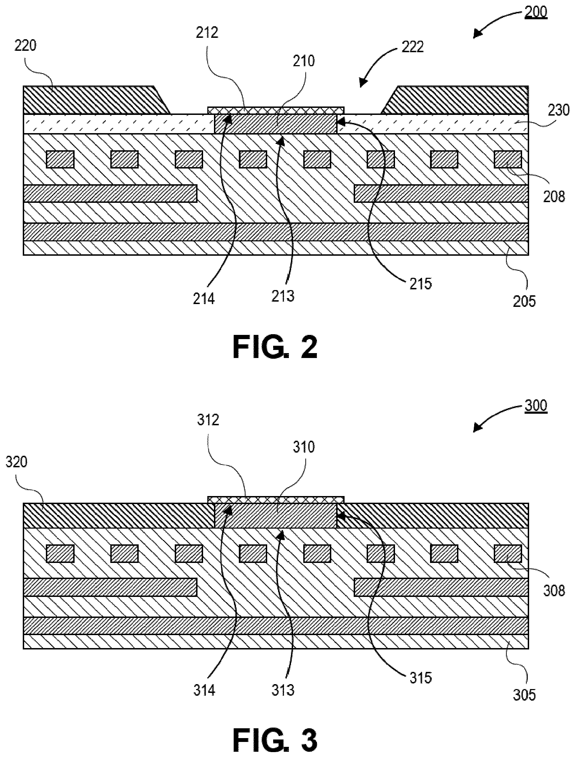

Referring now to Figure 2, a cross-sectional illustration of an electronic package 200 is shown, in accordance with an embodiment. In an embodiment, the electronic package 200 comprises a package substrate 205. The package substrate 205 may comprise dielectric buildup layers. In the illustrated embodiment, the package substrate 205 is shown as a coreless package substrate. However, it is to be appreciated that the package substrate 205 may be a cored package substrate 205 in some embodiments. In a cored package substrate 205, dielectric buildup layers may be provided above and below a core. In an embodiment, conductive routing 208 is provided in the package substrate 205. The conductive routing 208 may comprise pads, traces, vias, and the like. The conductive routing 208 provides electrical coupling from a die side of the package substrate 205 (i.e., the bottom surface in Figure 2) to the MD pad 210 on the land side of the package substrate 205 (i.e., the top surface in Figure 2).

In an embodiment, the electronic package 200 may comprise one or more MD pads 210 on the land side of the package substrate 205. The MD pad 210 may be provided over the dielectric buildup layers of the package substrate 205. For example, a first surface 213 of the MD pad 210 may be in contact with the underlying buildup layers of the package substrate 205. In an embodiment, the MD pad 210 comprises a second surface 214 facing away from the first surface 213. Sidewall surfaces 215 connect the first surface 213 to the second surface 214. In an embodiment, the sidewall surfaces 215 and the second surface 214 are above the buildup layers of the package substrate 205. That is, the MD pad 210 is not embedded in the package substrate 205.

In order to minimize stress concentrations at the footing of the MD pad 210 (i.e., at the corners of the MD pad 210 that contact the underlying package substrate 205), a stress relief dielectric layer 230 is provided along the sidewall surfaces 215 of the MD pad 210. The stress relief dielectric layer 230 may be a different material than the buildup layers of the package substrate 205 in some embodiments. In other embodiments, the stress relief dielectric layer 230 may be the same material as the buildup layers of the package substrate 205. The stress relief dielectric layer 230 may be a layer that extends over an entire top surface of the package substrate. That is, in some embodiments, the stress relief dielectric layer 230 is not merely localized at the edges of the MD pad 210. In an embodiment, the stress relief dielectric layer 230 comprises a thickness that is substantially equal to a thickness of the MD pad 210. The stress relief dielectric layer 230 may cover an entire height of the sidewalls 215 of the MD pad 210 without covering the second surface 214 of the MD pad 210.

In an embodiment, a solder resist layer 220 may be provided over the stress relief dielectric layer 230. The solder resist layer 220 may comprise a solder resist opening (SRO) 222. The SRO 222 may expose a top surface of the MD pad 210. For example, a width of the SRO 222 may be greater than a width of the MD pad 210. In an embodiment, sidewalls of the SRO 222 may be tapered, as shown in Figure 2. In other embodiments, the sidewalls of the SRO 222 may be substantially vertical.

In an embodiment, a surface finish 212 is provided over the second surface 214 of the MD pad 210. The surface finish 212 may be any suitable surface finish for microelectronic applications. For example, the surface finish 212 may comprise one or more layers. In an embodiment, the surface finish comprises electroless nickel electroless palladium immersion gold (ENEPIG), though other surface finishes may also be used. In an embodiment, the surface finish 212 may have a thickness that is less than approximately 10µm. In a particular embodiment, the surface finish 212 may have a thickness of approximately 6µm or less or approximately 3µm or less.

In an embodiment, the surface finish 212 is provided over only the second surface 214 of the MD pad 210. That is, the surface finish 212 does not cover the sidewall surfaces 215 of the MD pad 210, as is typical of existing MD pads, such as the one shown in Figure 1B. In an embodiment, the surface finish 212 may also extend over a portion of the stress relief dielectric layer 230. That is, the surface finish 212 may have a width that is greater than a width of the MD pad 210 in some embodiments.

While a dedicated stress relief dielectric layer 230 is shown in Figure 2, it is to be appreciated that embodiments are not limited to such configurations. For example, Figure 3 is a cross-sectional illustration of an electronic package 300 that utilizes the solder resist 320 as a stress relief layer for the MD pad 310 instead of using a stress relief dielectric layer 230.

As shown in Figure 3, the electronic package 300 comprises a package substrate 305. The package substrate 305 may comprise dielectric buildup layers. In the illustrated embodiment, the package substrate 305 is shown as a coreless package substrate. However, it is to be appreciated that the package substrate 305 may be a cored package substrate 305 in some embodiments. In a cored package substrate 305, dielectric buildup layers may be provided above and below a core. In an embodiment, conductive routing 308 is provided in the package substrate 305. The conductive routing 308 may comprise pads, traces, vias, and the like. The conductive routing 308 provides electrical coupling from a die side of the package substrate 305 (i.e., the bottom surface in Figure 3) to the MD pad 310 on the land side of the package substrate 305 (i.e., the top surface in Figure 3).

In an embodiment, the electronic package 300 may comprise one or more MD pads 310 on the land side of the package substrate 305. The MD pad 310 may be provided over the dielectric buildup layers of the package substrate 305. For example, a first surface 313 of the MD pad 310 may be in contact with the underlying buildup layers of the package substrate 305. In an embodiment, the MD pad 310 comprises a second surface 314 facing away from the first surface 313. Sidewall surfaces 315 connect the first surface 313 to the second surface 314. In an embodiment, the sidewall surfaces 315 and the second surface 314 are above the buildup layers of the package substrate 305. That is, the MD pad 310 is not embedded in the package substrate 305.

In order to provide stress reductions at the footing of the MD pad 310 (i.e., at the corners of the MD pad 310 contacting the underlying package substrate 305), a solder resist layer 320 may be in direct contact with the sidewalls 315 of the MD pad 310. Such an embodiment is distinct from existing SMD pads in that the solder resist layer 320 does not contact a top surface of the MD pad 310. In an embodiment, the solder resist layer 320 comprises a thickness that is substantially equal to a thickness of the MD pad 310. The solder resist layer 320 may cover an entire height of the sidewalls 315 of the MD pad 310 without covering the second surface 314 of the MD pad 310.

In an embodiment, a surface finish 312 is provided over the second surface 314 of the MD pad 310. The surface finish 312 may be any suitable surface finish for microelectronic applications. For example, the surface finish 312 may comprise one or more layers. In an embodiment, the surface finish comprises ENEPIG, though other surface finishes may also be used. In an embodiment, the surface finish 312 may have a thickness that is less than approximately 10µm. In a particular embodiment, the surface finish 312 may have a thickness of approximately 6µm or less or approximately 3µm or less.

In an embodiment, the surface finish 312 is provided over only the second surface 314 of the MD pad 310. That is, the surface finish 312 does not cover the sidewall surfaces 315 of the MD pad 310, as is typical of existing MD pads, such as the one shown in Figure 1B. In an embodiment, the surface finish 312 may also extend over a portion of the solder resist layer 320. That is, the surface finish 312 may have a width that is greater than a width of the MD pad 310 in some embodiments.

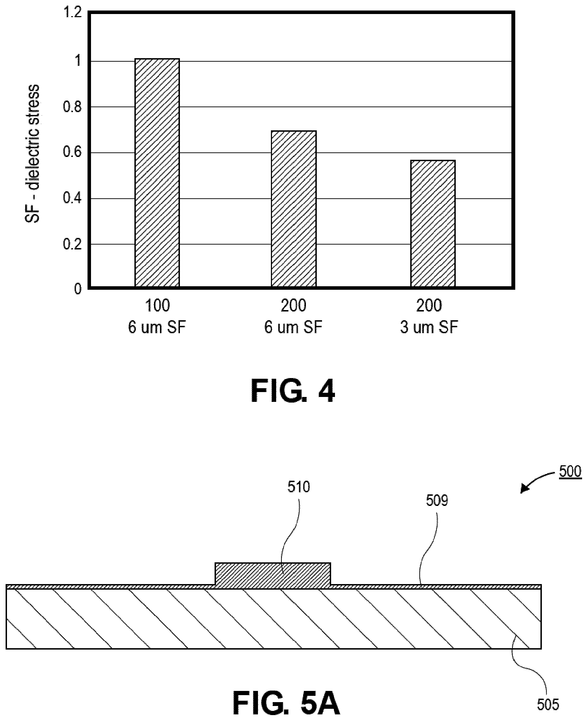

Referring now to Figure 4, a chart illustrating the stress proximate to the footing of the MD pad at an interface between the surface finish (SF) and the buildup layer is shown. The first bar illustrates the stress of at a typical MD pad with a 6µm thick surface finish, similar to an MD pad 110 shown in electronic package 100. The stress of the first bar is shown as 1. That is, the stress values shown in the other bars are normalized to the level of stress in the first bar. The second bar illustrates the stress at a footing of an MD pad 210 with a 6µm thick surface finish, similar to an MD pad 210 in electronic package 200 shown in Figure 2. As compared to the first bar, the stress is reduced by approximately 30% by using a dielectric stress relief layer. As shown in the third bar, reducing the surface finish thickness to approximately 3µm reduces the stress by approximately 10% more. Similar reductions in the stress may also be provided when using the solder resist layer as a stress relief layer for the MD pads, similar to the embodiment shown in Figure 3.

Referring now to Figures 5A-5F, a series of cross-sectional illustrations depicting a process for forming an electronic package 500 is shown, in accordance with an embodiment. In an embodiment, the electronic package 500 in Figures 5A-5F includes a stress relief dielectric layer 530 for minimizing stress concentrations at a footing of an MD pad 510.

Referring now to Figure 5A, a cross-sectional illustration of an electronic package 500 is shown, in accordance with an embodiment. In an embodiment, the electronic package 500 comprises a package substrate 505. The package substrate 505 may comprise dielectric buildup layers with conductive routing (not show) embedded therein. The package substrate 505 may be cored or coreless. In an embodiment, a seed layer 509 is provided over the package substrate 505. The seed layer 509 may be used to plate an MD pad 510. The plating process may be implemented with a mask layer (not shown) over portions of the seed layer 509 adjacent to where the MD pad 510 is desired. The MD pad 510 may be above the package substrate 505. That is, the MD pad 510 is not embedded in the package substrate 505.

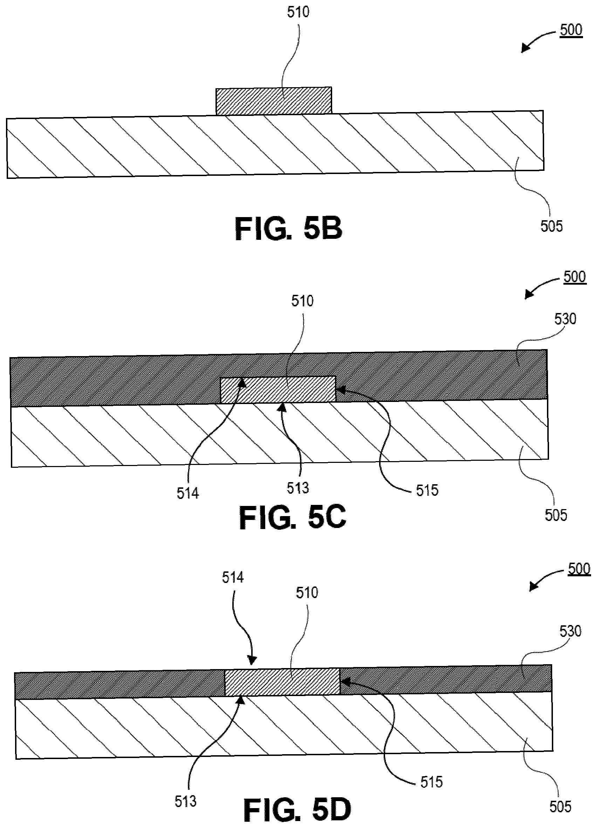

Referring now to Figure 5B, a cross-sectional illustration of the electronic package 500 after the seed layer 509 is removed is shown, in accordance with an embodiment. In an embodiment, the seed layer 509 may be removed with a seed layer etching process, such as a flash etching process.

Referring now to Figure 5C, a cross-sectional illustration of the electronic package 500 after a stress relief dielectric layer 530 is disposed over the MD pad 510 is shown, in accordance with an embodiment. In an embodiment, the stress relief dielectric layer 530 may be deposited with a lamination process or any other suitable deposition process. In an embodiment, the stress relief dielectric layer 530 comprises a material different than the buildup layers of the package substrate 505. In other embodiments, the stress relief dielectric layer 530 may comprise the same material as the underlying buildup layers of the package substrate 505.

In an embodiment, the stress relief dielectric layer 530 may embed the MD pad 510. For example, the stress relief dielectric layer 530 may be in direct contact with sidewall surfaces 515 and a second surface 514 of the MD pad 510. The first surface 513 of the MD pad 510 may be over the underlying package substrate 505.

Referring now to Figure 5D, a cross-sectional illustration of the electronic package 500 after the stress relief dielectric layer 530 is recessed is shown, in accordance with an embodiment. In an embodiment, the stress relief dielectric layer 530 is recessed with a planarization process or the like. In an embodiment, recessing the stress relief dielectric layer 530 exposes the second surface 514 of the MD pad 510. That is, sidewall surfaces 515 may remain covered by the stress relief dielectric layer 530. In an embodiment, a thickness of the stress relief dielectric layer 530 is substantially equal to a thickness of the MD pad 510.

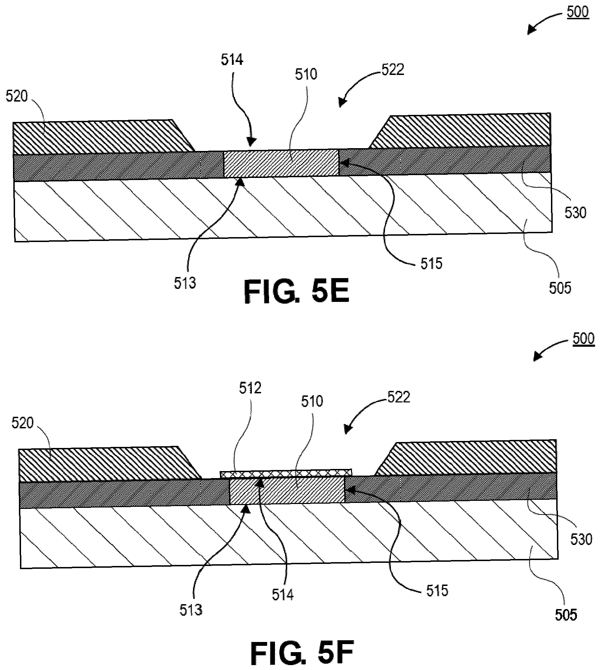

Referring now to Figure 5E, a cross-sectional illustration of the electronic package 500 after a solder resist layer 520 is disposed over the stress relief dielectric layer 530 is shown, in accordance with an embodiment. In an embodiment, the solder resist layer 520 may be deposited with a lamination process. A SRO 522 may be provided through the solder resist layer 520. In an embodiment, a width of the SRO 522 may be greater than a width of the MD pad 510. As such, portions of the stress relief dielectric layer 530 may also be exposed by the SRO 522. In an embodiment, the sidewalls of the SRO 522 may be tapered or substantially vertical.

Referring now to Figure 5F, a cross-sectional illustration of the electronic package 500 after a surface finish 512 is provided over the MD pad 510 is shown, in accordance with an embodiment. In an embodiment, the surface finish 512 may comprise any material (or materials) common of surface finishes for interconnects in microelectronic applications. For example, the surface finish 512 may comprise ENEPIG or the like. In an embodiment, a thickness of the surface finish 512 may be approximately 10µm or less. In a particular embodiment, the surface finish 512 may be approximately 6µm or less or approximately 3µm or less.

In an embodiment, the surface finish 512 is provided over the second surface 514 of the MD pad 510. The stress relief dielectric layer 530 protects the sidewall surfaces 515 and blocks deposition of the surface finish 512. That is, only the second surface 514 of the MD pad 510 is covered by the surface finish 512. In an embodiment, a width of the surface finish 512 may be greater than a width of the MD pad 510. As such, portions of the surface finish 512 may also contact the top surface of the stress relief dielectric layer 530.

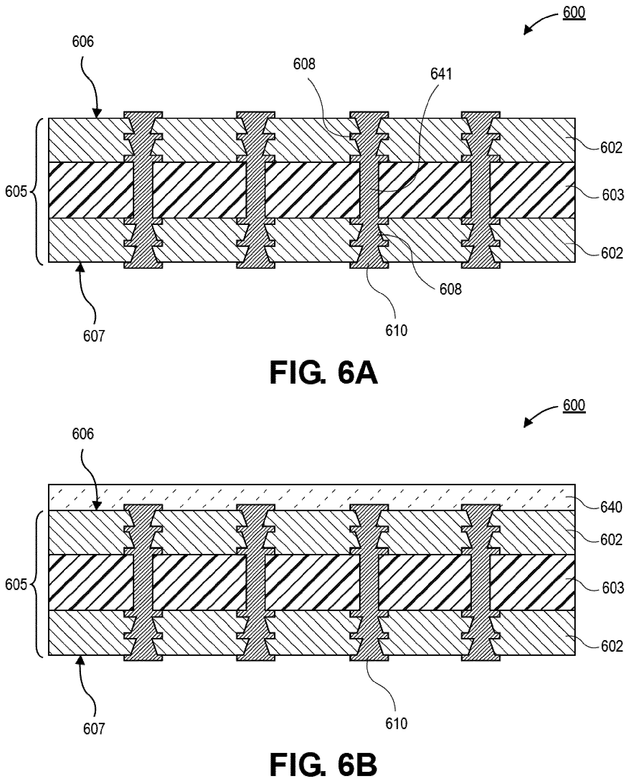

Referring now to Figures 6A-6I, a series of cross-sectional illustrations depicting a process flow for forming an electronic package 600 is shown, in accordance with an embodiment. In an embodiment, the electronic package 600 comprises a stress relief dielectric layer 630 over sidewall surfaces of an MD pad 610.

Referring now to Figure 6A, a cross-sectional illustration of an electronic package 600 is shown, in accordance with an embodiment. In an embodiment, the electronic package 600 comprises a package substrate 605. The package substrate 605 comprises a core 603 with dielectric routing layers 602 above and below the core 603. Conductive routing 608 is provided in the routing layers 602, and through core vias 641 are provided through the core 603. The package substrate 605 may comprise a die side 606 and a land side 607. In an embodiment, MD pads 610 are provided on the land side 607.

Referring now to Figure 6B, a cross-sectional illustration of the electronic package 600 after a protective layer 640 is formed over the die side 606 of the package substrate 605 is shown, in accordance with an embodiment. The protective layer 640 may be disposed with a lamination process or the like.

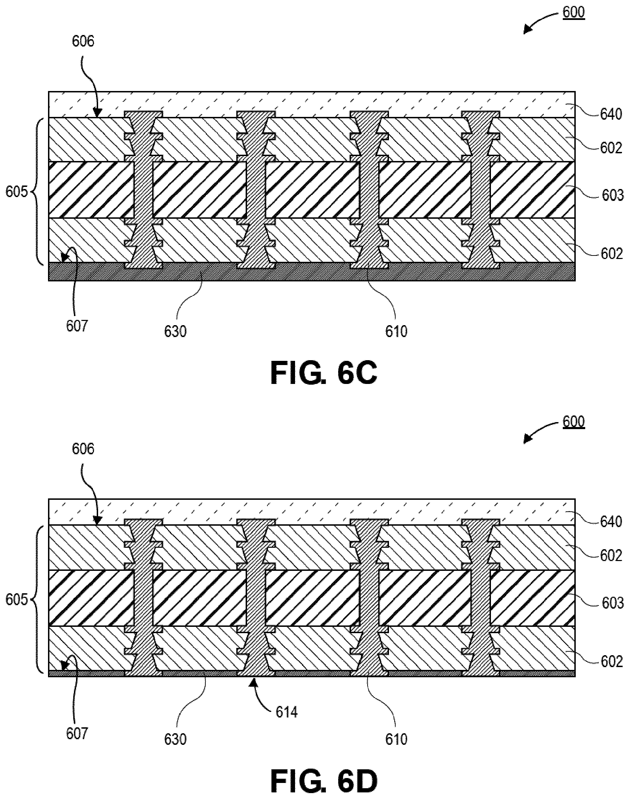

Referring now to Figure 6C, a cross-sectional illustration of the electronic package 600 after a stress relief dielectric layer 630 is provided over the land side 607 is shown, in accordance with an embodiment. In an embodiment, the stress relief dielectric layer 630 is formed over the MD pads 610. The stress relief dielectric layer 630 may be the same material as the dielectric routing layers 602. In other embodiments, the stress relief dielectric layer 630 comprises a material different than the dielectric routing layers 602.

Referring now to Figure 6D, a cross-sectional illustration of the electronic package 600 after the stress relief dielectric layer 630 is recessed is shown, in accordance with an embodiment. Recessing the stress relief dielectric layer 630 may expose a surface 614 of the MD pads 610. Sidewall surfaces of the MD pads 610 may remain covered by the stress relief dielectric layer 630. In an embodiment, a thickness of the stress relief dielectric layer is substantially similar to a thickness of the MD pads 610.

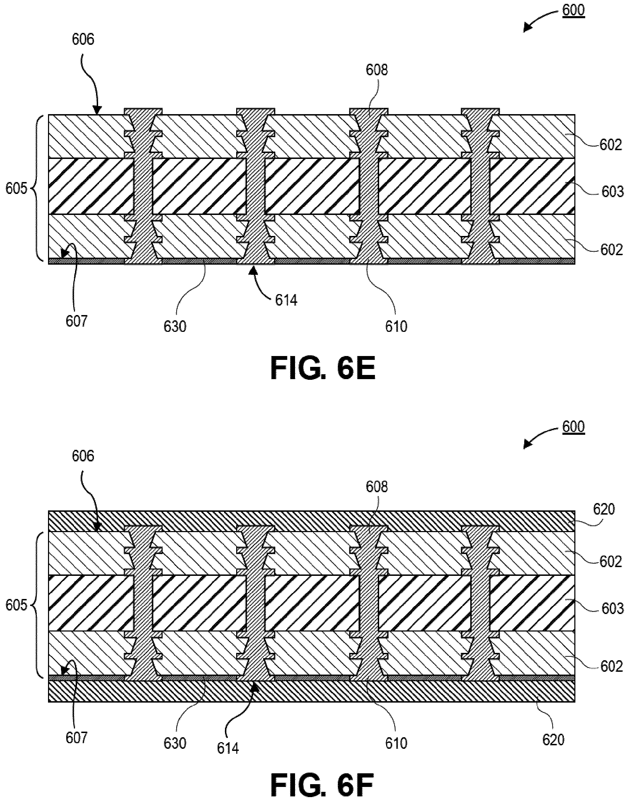

Referring now to Figure 6E, a cross-sectional illustration of the electronic package 600 after the protective layer 640 is removed from the die side 606 is shown, in accordance with an embodiment. The protective layer 640 may be removed with a stripping process or any other suitable process.

Referring now to Figure 6F, a cross-sectional illustration of the electronic package 600 after solder resist layers 620 are provided over the die side 606 and the land side 607 is shown, in accordance with an embodiment. In an embodiment, the solder resist layers 620 may be deposited with a lamination process or the like.

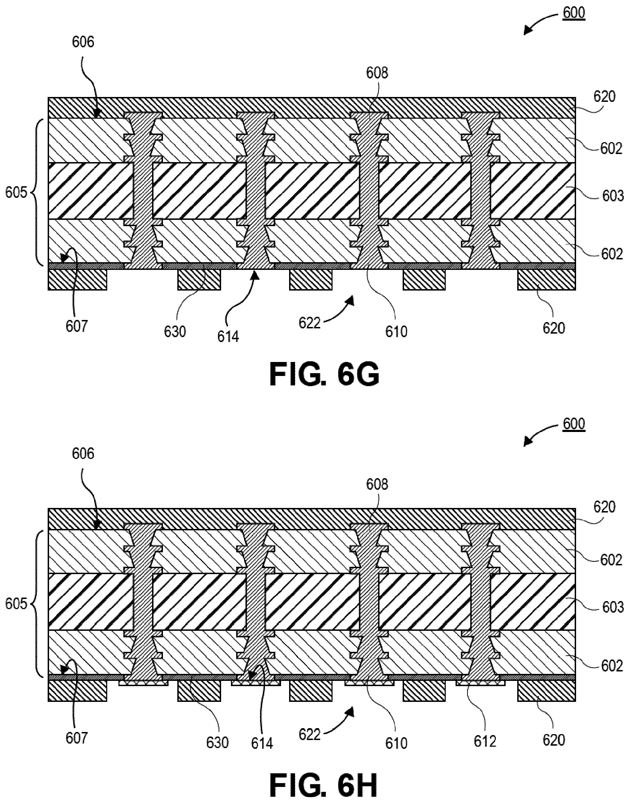

Referring now to Figure 6G, a cross-sectional illustration of the electronic package 600 after SROs 622 are formed through the land side 607 solder resist layer 620 is shown, in accordance with an embodiment. In an embodiment, the SROs 622 may have a width that is greater than a width of the MD pads 610. As such, the surface 614 of the MD pads 610 and a portion of the stress relief dielectric layer 630 are exposed by the SROs 622.

Referring now to Figure 6H, a cross-sectional illustration of the electronic package after surface finishes 612 are provided over the MD pads 610 is shown, in accordance with an embodiment. In an embodiment, the surface finishes 612 may comprise any material or materials typical of surface finishes in microelectronic applications, such as, for example, ENEPIG or the like. In an embodiment, the surface finishes 612 cover the surfaces 614 of the MD pads 610. Portions of the surface finishes 612 may also cover a portion of the stress relief dielectric layer 630.

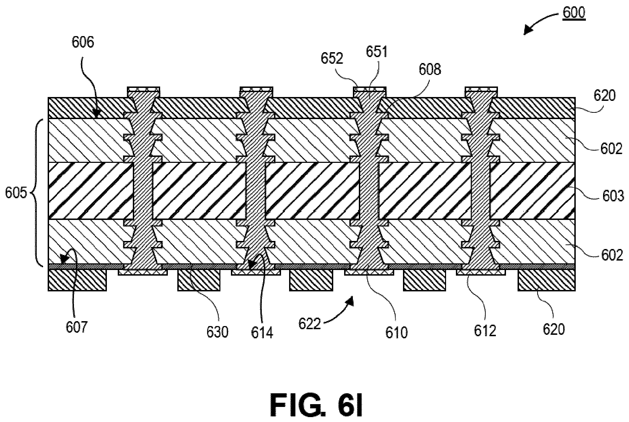

Referring now to Figure 6I, a cross-sectional illustration of the electronic package after first level interconnects (FLIS) 651 are formed over the die side 606 of the package substrate 605 is shown, in accordance with an embodiment. The FLIs 651 may comprise a pad with a surface finish 652. Vias through the solder resist layer 620 may couple the FLIs 651 to underlying conductive routing 608.

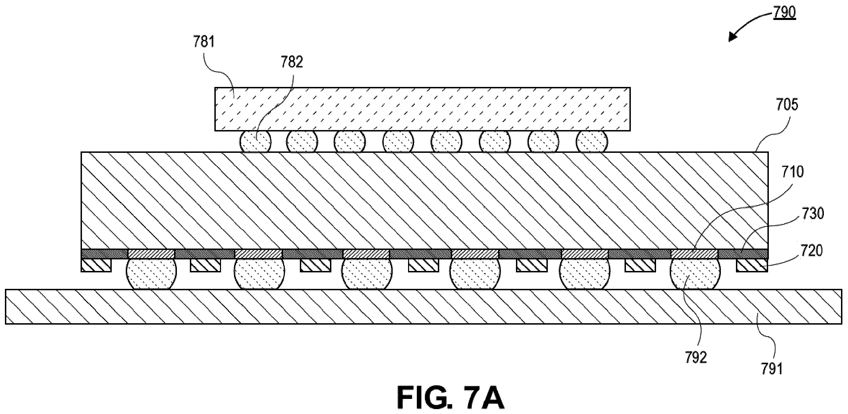

Referring now to Figure 7A, a cross-sectional illustration of an electronic system 790 is shown, in accordance with an embodiment. In an embodiment, the electronic system may comprise a board 791, such as a printed circuit board (PCB) or the like. In an embodiment, the board 791 is coupled to a package substrate 705 by interconnects 792, such as solder balls. The interconnects 792 may pass through a solder resist layer 720 and contact MD pads 710 on the package substrate 705. The MD pads 710 may have sidewalls that directly contact a stress relief dielectric layer 730. In an embodiment, a die 781 is coupled to a die side of the package substrate 705 by FLIs 782.

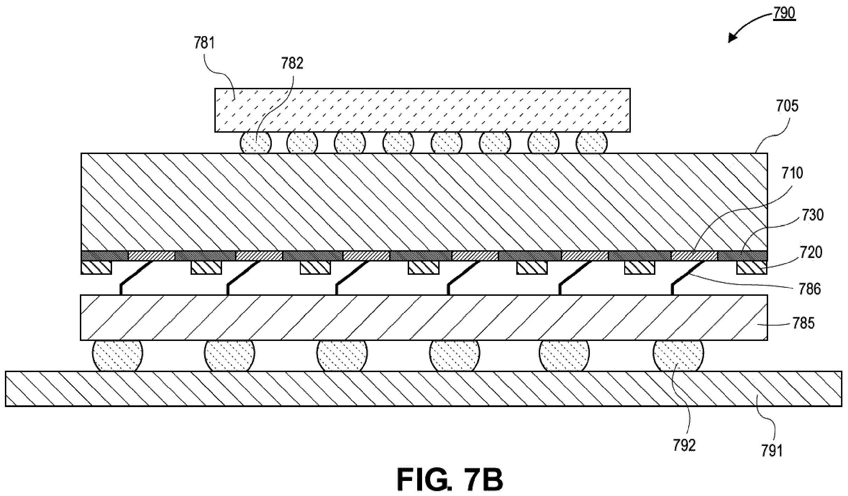

Referring now to Figure 7B, a cross-sectional illustration of an electronic system 790 is shown, in accordance with an embodiment. The electronic system 790 in Figure 7B may be substantially similar to the electronic system 790 in Figure 7A, with the exception of the interconnect between the package substrate 705 and the board 791. Instead of a solder ball interconnect, a socket architecture may be used. The socket architecture may comprise pins 786 that pass through a socket housing 785. The bottom of the pins 786 (at the bottom of the socket housing 785) may be coupled to the board by solder interconnects 792.

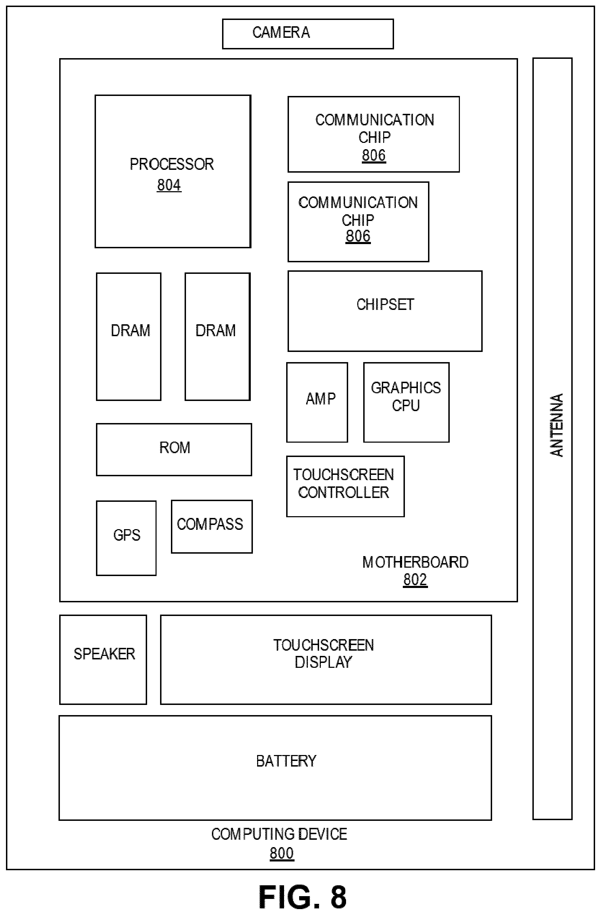

Figure 8 illustrates a computing device 800 in accordance with one implementation of the invention. The computing device 800 houses a board 802. The board 802 may include a number of components, including but not limited to a processor 804 and at least one communication chip 806. The processor 804 is physically and electrically coupled to the board 802. In some implementations the at least one communication chip 806 is also physically and electrically coupled to the board 802. In further implementations, the communication chip 806 is part of the processor 804.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 806 enables wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 800 may include a plurality of communication chips 806. For instance, a first communication chip 806 may be dedicated to shorter range wireless communications such as Wi-Fi and Bluetooth and a second communication chip 806 may be dedicated to longer range wireless communications such as GPS, EDGE, GPRS, CDMA, WiMAX, LTE, Ev-DO, and others.

The processor 804 of the computing device 800 includes an integrated circuit die packaged within the processor 804. In some implementations of the invention, the integrated circuit die of the processor may be part of an electronic package that comprises a package substrate with MD land side pads with stress relief features, in accordance with embodiments described herein. The term "processor" may refer to any device or portion of a device that processes electronic data from registers and/or memory to transform that electronic data into other electronic data that may be stored in registers and/or memory.

The communication chip 806 also includes an integrated circuit die packaged within the communication chip 806. In accordance with another implementation of the invention, the integrated circuit die of the communication chip may be part an electronic package that comprises a package substrate with MD land side pads with stress relief features, in accordance with embodiments described herein.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.

Example 1: an electronic package, comprising: a package substrate with a die side and a land side; a pad on the land side; a dielectric layer covering sidewalls of the pad; and a surface finish over an exposed surface of the pad.

Example 2: the electronic package of Example 1, wherein the dielectric layer is a different material than a layer of the package substrate.

Example 3: the electronic package of Example 1 or Example 2, wherein the dielectric layer is a solder resist.

Example 4: the electronic package of Example 3, wherein the solder resist does not cover any portion of a top surface of the pad facing away from the package substrate.

Example 5: the electronic package of Examples 1-4, wherein the surface finish extends over a top surface of the dielectric layer.

Example 6: the electronic package of Example 1-5, further comprising: a solder resist over the dielectric layer.

Example 7: the electronic package of Example 6, wherein an opening through the solder resist that exposes a top surface of the pad is wider than the pad.

Example 8: the electronic package of Example 7, wherein the pad is a metal defined pad.

Example 9: the electronic package of Examples 1-8, further comprising: a die attached to the die side of the package substrate.

Example 10: the electronic package of Examples 1-9, wherein the die is coupled to the pad by conductive routing through a thickness of the package substrate.

Example 11: a method of forming an electronic package, comprising: forming a pad on a land side of a package substrate; disposing a dielectric layer over the pad; and recessing the dielectric layer to expose a surface of the pad, wherein the dielectric layer remains over sidewall surfaces of the pad.

Example 12: the method of Example 11, further comprising: disposing a solder resist over the dielectric layer and the pad, wherein an opening through the dielectric layer exposes the surface of the pad.

Example 13: the method of Example 12, wherein a width of the opening through the dielectric layer is wider than a width of the pad.

Example 14: the method of Example 13, further comprising: disposing a surface finish over the surface of the pad.

Example 15: the method of Example 14, wherein the surface finish extends over the dielectric layer.

Example 16: the method of Examples 11-15, wherein the dielectric layer is a solder resist.

Example 17: the method of Example 16, further comprising: disposing a surface finish over the surface of the pad.

Example 18: the method of Examples 11-17, wherein a die side of the package substrate is covered by a protective film during the operation of recessing the dielectric layer.

Example 19: the method of Examples 11-18, further comprising: forming first level interconnects on a die side of the package substrate after exposing the surface of the pad.

Example 20: a land side interconnect of a package substrate, comprising: a pad over a land side the package substrate, wherein the pad has a first surface connected to a via, a second surface opposite from the first surface, and sidewall surfaces connecting the first surface to the second surface; and a dielectric layer over the land side of the package substrate and directly contacting the sidewall surfaces of the pad, wherein the dielectric layer does not contact the second surface of the pad.

Example 21: the land side interconnect of Example 20, further comprising: a solder resist layer over the dielectric layer.

Example 22: the land side interconnect of Example 21, wherein an opening through the solder resist layer exposes the second surface of the pad, wherein the solder resist layer does not contact the second surface of the pad.

Example 23: the land side interconnect of Example 20-22, further comprising: a surface finish over the second surface of the pad.

Example 24: an electronic system, comprising: a board; a package substrate coupled to the board; land side interconnects on the package substrate, wherein individual ones of the land side interconnects comprise: a pad over a land side the package substrate, wherein the pad has a first surface connected to a via, a second surface opposite from the first surface, and sidewall surfaces connecting the first surface to the second surface; a dielectric layer over the land side of the package substrate and directly contacting the sidewall surfaces of the pad, wherein the dielectric layer does not contact the second surface of the pad; and a die coupled to a die side of the package substrate.

Example 25: the electronic system of Example 24, further comprising: a solder resist over the dielectric layer, wherein the solder resist does not contact the second surface of the pad.

## Claims

1. An electronic package, comprising:
a package substrate with a die side and a land side;
a pad on the land side;
a dielectric layer covering sidewalls of the pad; and
a surface finish over an exposed surface of the pad.

2. The electronic package of claim 1, wherein the dielectric layer is a different material than a layer of the package substrate.

3. The electronic package of claim 1 or 2, wherein the dielectric layer is a solder resist.

4. The electronic package of claim 3, wherein the solder resist does not cover any portion of a top surface of the pad facing away from the package substrate.

5. The electronic package of claim 1, 2, 3 or 4, wherein the surface finish extends over a top surface of the dielectric layer.

6. The electronic package of claim 1, 2, 3, 4 or 5, further comprising:
a solder resist over the dielectric layer.

7. The electronic package of claim 6, wherein an opening through the solder resist that exposes a top surface of the pad is wider than the pad.

8. The electronic package of claim 7, wherein the pad is a metal defined pad.

9. The electronic package of claim 1, 2, 3, 4, 5, 6, 7 or 8, further comprising:
a die attached to the die side of the package substrate.

10. The electronic package of claim 1, 2, 3, 4, 5, 6, 7, 8 or 9, wherein the die is coupled to the pad by conductive routing through a thickness of the package substrate.

11. A method of forming an electronic package, comprising:
forming a pad on a land side of a package substrate;
disposing a dielectric layer over the pad; and
recessing the dielectric layer to expose a surface of the pad, wherein the dielectric layer remains over sidewall surfaces of the pad.

12. The method of claim 11, further comprising:
disposing a solder resist over the dielectric layer and the pad, wherein an opening through the dielectric layer exposes the surface of the pad.

13. The method of claim 12, wherein a width of the opening through the dielectric layer is wider than a width of the pad.

14. The method of claim 13, further comprising:
disposing a surface finish over the surface of the pad.

15. The method of claim 14, wherein the surface finish extends over the dielectric layer.
